(19) 【Europäisches Patentamt / European Patent Office / Office européen des brevets】

(11) **EP 2 230 806 B1**

(12) **EUROPEAN PATENT SPECIFICATION**

(45) Date of publication and mention
of the grant of the patent:
**23.11.2011 Bulletin 2011/47**

(51) Int Cl.:
***H04L 25/03*** *(2006.01)*      ***H04L 25/02*** *(2006.01)*

(21) Application number: **09155634.0**

(22) Date of filing: **19.03.2009**

(54) **Method and device for filtering with FIR filters**

Verfahren und Vorrichtung zur Signalfilterung mit FIR-Filtern

Procédé et dispositif de filtrage avec des filtres FIR

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(43) Date of publication of application:
**22.09.2010 Bulletin 2010/38**

(73) Proprietors:
• **Mitsubishi Electric R&D Centre Europe B.V.**
**1119 NS Schiphol Rijk (NL)**
Designated Contracting States:
**FR**
• **MITSUBISHI ELECTRIC CORPORATION**
**Chiyoda-ku**
**Tokyo 100-8310 (JP)**
Designated Contracting States:
**AT BE BG CH CY CZ DE DK EE ES FI GB GR HR
HU IE IS IT LI LT LU LV MC MK MT NL NO PL PT
RO SE SI SK TR**

(72) Inventors:
• **Bouttier, Arnaud**
**35708 Rennes Cedex (FR)**
• **Nourisson, Xavier**
**35708 Rennes Cedex (FR)**

(74) Representative: **Maillet, Alain**
**Cabinet Le Guen Maillet**
**5, place Newquay**
**B.P. 70250**
**35802 Dinard Cedex (FR)**

(56) References cited:
**US-A- 5 031 194       US-A1- 2003 048 840
US-A1- 2009 067 520**

EP 2 230 806 B1

## Description

The invention generally relates to methods for implementing finite impulse response filters, called FIR filters where filtering is applied on finite sets of samples $X_i$. This invention was primarily designed to implement the Wiener filter used in some channel estimation techniques for OFDM.

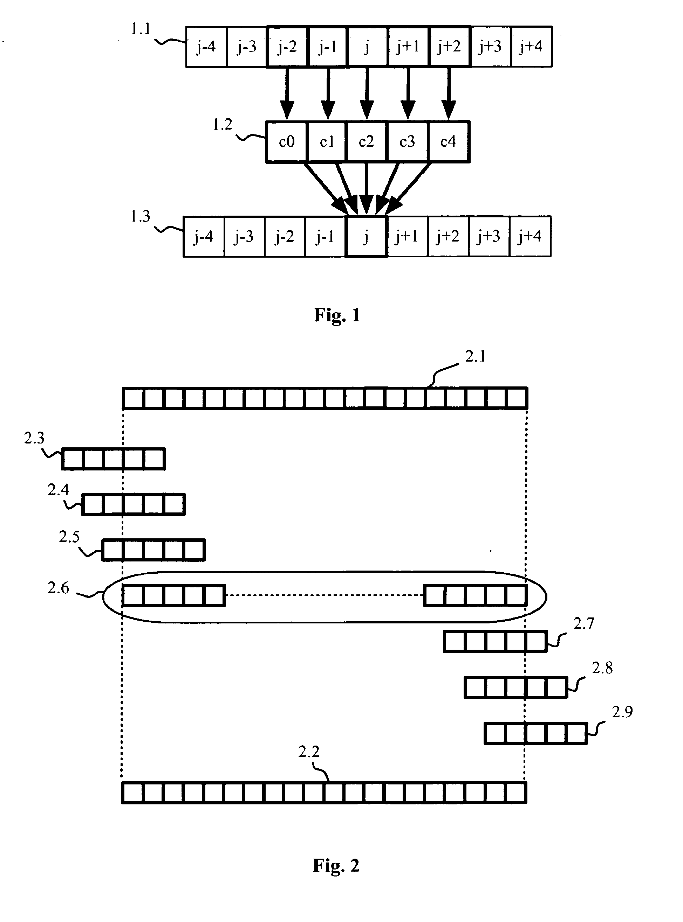

In the present invention, we only consider the case of FIR filters and more specifically linear phase FIR filters with an odd number of $M$ coefficients made of 2 sets of $L$ symmetrical coefficients around a central tap, i.e. $M=2.L+1$. The filter coefficients can either be real or complex numbers. The Fig. 1 illustrates one example of an FIR filter applied to a set of samples. The filter 1.2 is applied to a set 1.1 of input samples to get an output set of samples 1.3. The input and output set of samples are each constituted by a finite sequence of indexed samples. To obtain the value of an output sample of index $j$ the filter is applied to input samples of index $j$-$L$ to $j$+$L$ given a filter of width $M=2.L+1$ as far as the filter is centred. On the Fig. 1 M=5;

Calling $X_i$ the input set of samples for $i$ from $0$ to $N-1$.

Calling $Y_i$ the output set of samples for $i$ from $0$ to $N-1$.

Calling $C_i$ the filter coefficients for $i$ from 0 to $2L$.

The computation of point of index j can be expressed as follows for j >L-1 and $j<N-L$ :

$$Y_j = \sum_{i=0}^{2.L} C_i * X_{j-L+i} \qquad (1)$$

or taking into account the symmetry of the filter :

$$Y_j = C_L.X_J + \sum_{i=0}^{L-1} C_i.(X_{j-L+i} + X_{j+L-i}) \qquad (2)$$

This equation is representative of the so-called stationary mode meaning the computation of indexes $L$ to $N-L-1$. It represents the computation of the output samples using filter applied in their entirety to input samples. Computation of edge samples, thus samples with indexes from 0 to $L-1$ and from $N-L$ to $N-1$, is called the transient mode. To compute the transient mode we need to cope with the problem of applying the filter to an incomplete set of samples.

Some solutions to this problem have been proposed in the past.

Document US 2009/0067520 A1 discloses a method of channel estimation in OFDM communication using a Wiener filter as one of these solutions. A further solution consists in affecting the value zero to missing input samples keeping the filter unchanged to compute the transient samples. The output samples obtained by feeding an FIR filter with zeros are not exploitable and are generally ignored in the rest of the operations. This is not acceptable in all applications.

Another solution consists in computing the L first samples from the same set of $M$ samples, the size of the filter, but with different sets of coefficients. The following samples are then computed normally with the same set of coefficients. Similarly as for the first edge, the last $L$ samples are computed from the same set of $M$ samples but with different sets of coefficients. As the width of the FIR filter is generally chosen to accurately reflect the distance of influence of input samples, this technique takes into account needlessly far input samples. This leads to useless computation for transient samples.

The invention presented in this document addresses these problems by proposing a FIR filter computation method dealing more accurately with the transient mode computation. It is based on a variable width of the filter used to compute the transient mode. Moreover the proposed solution is easy to implement using only $L+1$ real or complex multipliers for the stationary mode as well as the transient mode.

The invention concerns a method according to independent claim 1.

The invention also concerns a filtering device according to independent claim 2 and dependent claims 3 and 4.

The characteristics of the invention will emerge more clearly from a reading of the following description of an example embodiment, the said description being produced with reference to the accompanying drawings, among which:

Fig. 1 illustrates one example of FIR filter applied to a set of samples,

Fig. 2 illustrates one example of FIR filter applied to a finite set of samples with transient and stationary modes according to prior art,

Fig. 3 illustrates one example of FIR filter applied to a finite set of samples with transient and stationary modes according to prior art,
Fig. 4 illustrates one example of FIR filter applied to a finite set of samples with transient and stationary modes according to the invention,
Fig. 5 illustrates the implementation of the FIR filtering in one exemplary embodiment of the invention.

The invention, while being applicable in all domains where FIR filters, symmetric and centred, have to be applied to a finite set of samples, has been developed in the field of digital transmission where information bits are transmitted periodically in time as a stream of encoded symbols. It is well suited in the case where the transmission uses a multi-carrier technique like OFDM (Orthogonal Frequency Division Multiplexing). Using this transmission technique, samples are transmitted on a finite set of sub-carriers. The decoding implies an operation of equalization using the knowledge of the transmission channel. This transmission channel is estimated from the transmission of known reference pilot signals. After FFT, the contribution of the reference symbols is cancelled out by an appropriate means such as a basic division to finally obtain an estimation of the channel coefficients. Just as other symbols, the reference pilots are affected by noise. As OFDM is known to be very sensitive to errors on channel estimates, it is preferable to reduce the impact of noise. A basic solution consists in removing the noise falling outside the guard interval by a multiplication with a rectangular filter of the channel response in the time domain, e.g. after IFFT on the channel coefficients. But channel estimation and equalization are performed in the frequency domain. To avoid the computation of additional FFTs, the reduction of the noise contribution can also be achieved by convolution, i.e. through digital filtering, in the frequency domain. Depending on their structure, digital filters can implement both finite (FIR) and infinite (IIR) impulse responses. With poles in their transfer functions, IIR filters can achieve very selective frequency with few coefficients. But these poles also make IIR filters potentially unstable while FIR filters are intrinsically BIBO (Bounded Input, Bounded Output) stable. When it comes to actual implementation, IIR filters also appear as sensitive to quantization errors. Dealing with channel estimation, it is critical not to alter the information carried by the sub-carriers, i.e. the filter must be ideally flat and linear in phase over the passband. As the constraints in terms of selectivity are not stringent, it is common to use FIR filters. One approach consists in computing them according to a performance criterion, typically the Minimum Mean Square Error (MMSE), leading to the so-called Wiener filter. The computation of the optimal Wiener requires the knowledge of the channel response. To simplify the receiver, it is common to assume a fixed channel, typically equal to one over the guard interval duration. The performance obtained with this approach is fairly acceptable in comparison with the optimal filter. It is also very common to shift the OFDM multiplex by half the guard interval duration to make the Wiener filter coefficients real, thus reducing the overall complexity. The advantage of this solution is also to obtain a symmetrical filter.

For the samples of rank j, all samples with a lower rank are described as belonging to past of the sample, left-hand side samples. Alternatively, all samples with a higher rank are described as belonging to future of the sample, right-hand side samples. The FIR filters considered here are by essence non-causal and are made causal by shift and truncation on the theoretical response. This means that filtering input samples from rank $j$ down to $j$-M+1 provides the output sample relative to the input sample with rank $j$-L.

Fig. 2 illustrates the application of a symmetric and centred FIR filter to a finite set of samples. The input finite set of samples is referenced 2.1. It contains $N$ input samples indexed from $0$ to $N-1$. This input set of samples is filtered by a filter with a width of $M=5$ on this figure to produce an output set of filtered samples 2.2 with the same number of samples. The filter 2.3 is not actually used, its result falling out of the scope of the output set. The first sample of output is obtained by application of filter 2.4 to the first three samples of input. Typically, the two first values used to compute this filter are set to zero. The second sample of output is obtained by application of filter 2.5 to the first four samples of input. Typically, the first value used to compute this filter is set to zero. The situation is symmetric for the two last samples using filters 2.7 and 2.8. The computation of the two first and two last samples represents the transient mode where the filter used for the computation does not fit entirely on actual input samples. The computation of all other output samples from index $2$ to N-$3$ represents the stationary mode, reference 2.6, where the filter entirely fits on actual input samples.

Due to the poor results obtained in the transient mode by inserting virtual samples with a value zero, the transient result is often discarded in the prior art for the rest of operation. This is obviously not possible in the present case where all the sub-carriers equally contribute to carrying information.

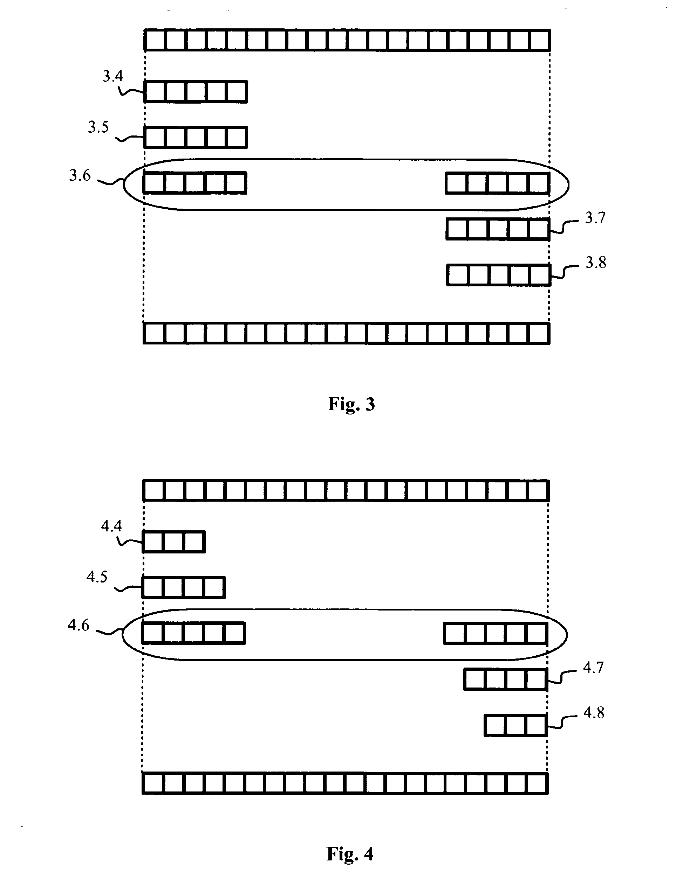

Another known solution consists in computing the $L$ first samples from the same set of $M$ samples but with different sets of coefficients. The following samples are then computed normally with the same set of coefficients. Similarly as for the first edge, the last $L$ samples are computed from the same set of $M$ samples but with different sets of coefficients. One advantage of the MMSE criterion is to make simple the computation of the band edges coefficients. This solution is illustrated on Fig. 3 where filter 3.4 of width $M$ applied on the $M$ first input samples is used to compute the first output sample. Filter 3.5 of same width $M$ applied on the M first input samples is used to compute the second output sample. The stationary mode 3.6 is computed as usual using a symmetric centred FIR filter. Filters 3.7 and 3.8 are used to compute the $L$ last samples. Obviously, the transient filters are neither symmetric nor centred; their coefficients have to be different from the coefficients of the regular filter used for the stationary mode.

The drawback of these solutions is double. On one hand, they take into account input samples which distance from the output value to be computed is more than L which does not make sense in an application where the width of the filter is chosen to be *2.L+1.* On another hand, the computation of the stationary mode could be achieved using *L+1* multipliers as can be deduced from equation 2. The computation of the transient samples cannot be achieved using L+1 multipliers, because the transient filters are not symmetric, leading to extra hardware, in particular multipliers, needed to implement the computation.

The proposed solution is based on applying a transient filter with a variable length. One assumption is that input sample at a distance greater than *L-1* from the output brings few information to compute the result. It enables to perform the filtering of the transient periods with the reduced complexity of *L*+1 multiplications, taking advantage of the symmetrical response, and performance close to the ones obtained with a full length filter of 2.*L*+1 coefficients. Therefore, the first output sample of index 0 is computed using a filter of size *L+1* covering the *L+1* first samples of input. A transient sample of index *j* with *j<L* is computed with a filter of width j+L+1 applied to the *j+L+1* first samples of input. Thus for each new sample of the transient mode, the size of the filter is incremented from *L+1* to *2.L* for the last transient sample. We then enter the stationary mode with filter of size *2.L+1.* The same applies to the other edge symmetrically. The Fig. 4 illustrates this with a first transient filter 4.4 of size 3, a second filter 4.5 of size 4 corresponding to symmetric filters 4.7 and 4.8 for the other edge.

In this invention, we do not focus on the computation of the coefficients of filters that are supposed to be computed according to a known solution. For example, they can be estimated using the Wiener method in the exemplary embodiment.

The gain in terms of performance is obviously due to the fact that the length of the filter increases with the rank of sample to be filtered out. The filter always use*s L* future samples and all the available past samples. The parameter *L* of the filter is generally selected so as to benefit from most of the information available from past and future samples. It is therefore not detrimental to ignore the contribution of these samples on the filter output. The extension of the filter length also allows reducing the impact of the imperfections due for instance to the phase non-linearity. This reduces globally the number of operations required to compute the transient samples in comparison with the full-length *M* scenario. The second and main advantage of this approach is that the extra multiplications required for computing the transient samples can be spread over the computation of the L first unnecessary transient samples, i.e. just as if the block of samples was entirely filtered with an *M*-coefficient causal filter. The first *L* samples are simply discarded from the output as not carrying information but contribute for the computation of the useful transient samples with more than *2L*+1 coefficients. Doing so, only *L*+1 multipliers are required.

Dealing with implementation, it is important to save hardware resources for saving both area and power consumption. We focus here on the implementation of the FIR filter for channel estimation. In stationary mode, the filter can be selected as being symmetrical with an odd number of coefficients *M=2L+1.* Filtering can therefore be achieved using only *L+1* multipliers. The contribution to the output of the pairs of input samples weighted by the same filter coefficient can be done using the same multiplier where the multiplication is applied to the sum of the two input samples. Unfortunately, the filters to be applied in transient periods are not symmetrical. The implementation of the filter therefore requires *2.L+1* coefficients only for handling the band edges.

The Wiener filter reduces the noise contribution using the knowledge of the channel correlation. Each sample is correlated to its neighbouring samples on both sides. The size of the filter is generally chosen to benefit from most of the available information. On a block of samples, the first sample can only benefit from the information brought by the right-hand side samples. The quality of the noise reduction cannot therefore be as good as for samples in stationary mode. The second sample can benefit from the contribution of one past sample to remove slightly more noise.

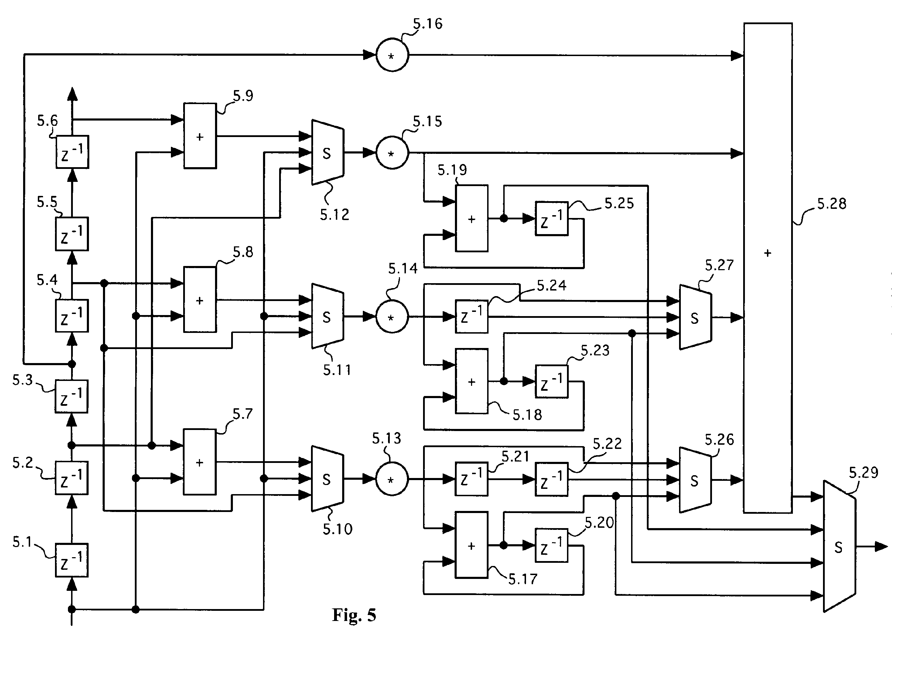

This method of computing FIR filters can be implemented using only *L+1* multipliers both for the transient mode and the stationary mode. This leads to a hardware that saves both power and surface. An example of such hardware is now described in relation with Fig. 5. This hardware is dedicated to the computation of FIR filters of width *M=7 (L=3).* On this figure the square marked $Z^{-1}$ are buffers to delay one cycle their input, rectangles marked with a plus sign are adders, rounds with a multiply sign are multipliers while trapezoids marked with a S sign are selectors. The first rank of buffers 5.1 to 5.6 allows the input samples to progress cycle by cycle. The three adders 5.7 to 5.9 are dedicated to add the symmetric inputs that have to be multiplied by the same coefficient during the stationary mode. The selectors 5.10 to 5.12 are used to select particular input for the following multipliers to cope with the transient mode as it will be explained later. Then, the four multipliers, *L+1* where here *L=3,* 5.13 to 5.16 are dedicated to the multiplication. In the stationary mode, the first three multipliers 5.13 to 5.15 will multiply the sum of inputs by the corresponding coefficient the last one 5.16 is dedicated to the multiplication of the central sample. The feeding of these multipliers by the right coefficient is not represented to avoid useless complexity of the figure. Then comes a sequence of accumulators constituted by an adder coupled with a buffer, 5.17 and 5.20, 5.18 and 5.23, 5.19 and 5.25, which goal is to accumulate the result of transient filters. The final adder 5.28 is there to compute the result of the filter, mainly during the stationary mode. While the final selector is used to select the output from the final adder of from one of the accumulator depending on the stage of computation, stationary or transient mode.

We will now describe an example of execution on an input sequence of ten samples. Let's call the input values $X_i$. The first transient filter has coefficients called $D_0$ to $D_2$. The second transient filter has coefficients called $E_0$ to $E_3$. The third transient filter has coefficients called $F_0$ to $F_4$. Symmetrically, the last transient filters have coefficients $G_0$ to $G_4$, $H_0$ to $H_3$ and $I_0$ to $I_2$. The stationary filter has coefficients called $C_0$ to $C_3$, in the disposition $C_0$, $C_1$, $C_2$, $C_3$, $C_2$, $C_1$, $C_0$.

On stage 1, $X_0$ is presented as input of the first buffer 5.1. It is also selected as the input of the three multipliers 5.13 to 5.15. The output of the first multiplier 5.13 is then $D_0.X_0$. The output of the second multiplier 5.14 is then $E_0.X_0$. The output of the third multiplier 5.15 is then $F_0.X_0$.

On stage 2, $X_0$ is presented as input of the second buffer 5.2. $X_1$ is presented as input of the first buffer 5.1. It is also selected as the input of the three multipliers 5.13 to 5.15. The output of the first multiplier 5.13 is then $D_1.X_1$. The output of the second multiplier 5.14 is then $E_1.X_1$. The output of the third multiplier 5.15 is then $F_1.X_1$. The output of the adder 5.17 of the first accumulator is $D_0.X_0+D_1.X_1$. The output of the adder 5.18 of the second accumulator is $E_0.X_0+E_1.X_1$. The output of the adder 5.19 of the third accumulator is $F_0.X_0+F_1.X_1$.

On stage 3, $X_0$ is presented as input of the third buffer 5.3. $X_1$ is presented as input of the second buffer 5.2. $X_2$ is presented as input of the first buffer 5.1. It is also selected as the input of the three multipliers 5.13 to 5.15. The output of the first multiplier 5.13 is then $D_2.X_2$. The output of the second multiplier 5.14 is then $E_2.X_2$. The output of the third multiplier 5.15 is then $F_2.X_2$. The output of the adder 5.17 of the first accumulator is $D_0.X_0+D_1.X_1+D_2.X_2$. The output of the adder 5.18 of the second accumulator is $E_0.X_0+E_1.X_1+E_2.X_2$. The output of the adder 5.19 of the third accumulator is $F_0.X_0+F_1.X_1 +F_2.X_2$.

On stage 4, $X_3$ is presented as input of the first buffer 5.1. It is also selected as the input of the three multipliers 5.13 to 5.15. The output of the first multiplier 5.13 is then $D_3.X_3$. The output of the second multiplier 5.14 is then $E_3.X_3$. The output of the third multiplier 5.15 is then $F_3.X_3$. The output of the adder 5.17 of the first accumulator is $D_0.X_0+D_1.X_1+D_2.X_2+D_3.X_3$, which is selected in 5.29 as the first output sample. The output of the adder 5.18 of the second accumulator is $E_0.X_0+E_1.X_1+E_2.X_2+E_3.X_3$. The output of the adder 5.19 of the third accumulator is $F_0.X_0+ F_1.X_1+ F_2.X_2+ F_3X_3$.

On stage 5, $X_4$ is presented as input of the first buffer 5.1. It is also selected as the input of the two multipliers 5.14 to 5.15. The output of the first multiplier 5.13 is then $C_2.(X_4+X_2)$. The output of the second multiplier 5.14 is then $E_4.X_4$. The output of the third multiplier 5.15 is then $F._4X_4$. The output of the adder 5.18 of the second accumulator is $E_0.X_0+E_1.X_1+E_2.X_2+E_3.X_3+E_4.X_4$, which is selected as the second output sample. The output of the adder 5.19 of the third accumulator is $F_0.X_0+F_1.X_1+F_2.X_2+F_3.X_3+F_4X_4$.

On stage 6, $X_5$ is presented as input of the first buffer 5.1. It is also selected as the input of the third multiplier 5.15. The output of the first multiplier 5.13 is then $C_2.(X_5+X_3)$. The output of the second multiplier 5.14 is then $C_1.(X_5+X_1)$. The output of the third multiplier 5.15 is then $F_5X_5$. The output of the adder 5.19 of the third accumulator is $F_0.X_0+F_1.X_1+F_2.X_2+F_3X_3+F_4X_4+F_5.X_5$, which is selected as the third output sample. The output of the buffer 5.21 is $C_2.(X_4+X_2)$.

On stage 7, $X_6$ is presented as input of the first buffer 5.1. The output of the first multiplier 5.13 is then $C_2.(X_6+X_4)$. The output of the second multiplier 5.14 is then $C_1.(X_6+X_2)$. The output of the third multiplier 5.15 is then $C_0.(X_6+X_0)$. The output of the fourth multiplier 5.16 is then $C_3.X_3$. The output of the buffer 5.21 is $C_2.(X_5+X_3)$. The output of the buffer 5.22 is $C_2.(X_4+X_2)$. The output of the buffer 5.23 is $C_1.(X_5+X_1)$. The output of the circuit is selected from the output of the adder 5.28 which is then $C_0.(X_6+X_0)+C_1.(X_5+X_1)+C_2.(X_4+X_2)+C_3.X_3$ corresponding to the first stationary output sample.

On stage 8, $X_7$ is presented as input of the first buffer 5.1. The output of the first multiplier 5.13 is then $C_2.(X_7+X_5)$. The output of the second multiplier 5.14 is then $C_1.(X_7+X_3)$. The output of the third multiplier 5.15 is then $C_0.(X_7+X_1)$. The output of the fourth multiplier 5.16 is then $C_3..X_4$. The output of the buffer 5.21 is $C_2.(X_6+X_4)$. The output of the buffer 5.22 is $C_2.(X_5+X_3)$. The output of the buffer 5.23 is $C_1.(X_6+X_2)$. The output of the circuit is selected from the output of the adder 5.28 which is then $C_0.(X_7+X_1)+C_1+(X_6+X_2)+C_2.(X_5+X_3)+C_3.X_4$ corresponding to the second stationary output sample.

On stage 9, $X_8$ is presented as input of the first buffer 5.1. The output of the first multiplier 5.13 is now $G_0.X_4$ due to a change in the selector 5.10. The output of the second multiplier 5.14 is then $C_1.(X_8+X_4)$. The output of the third multiplier 5.15 is then $C_0.(X_8+X_2)$. The output of the fourth multiplier 5.16 is then $C_3.X_5$. The output of the buffer 5.21 is $C_2.(X_7+X_5)$. The output of the buffer 5.22 is $C_2.(X_6+X_4)$. The output of the buffer 5.23 is $C_1.(X_7+X_3)$. The output of the circuit is selected from the output of the adder 5.28 which is then $C_0.(X_8+X_2)+C_1.(X_7+X_3)+C_2.(X_6+X_4)+C_3.X_5$ corresponding to the third stationary output sample.

On stage 10, $X_9$ is presented as input of the first buffer 5.1. The output of the first multiplier 5.13 is now $G_1.X_5$. The output of the second multiplier 5.14 is then $H_0.X_5$ due to a change in the selector 5.11. The output of the third multiplier 5.15 is then $C_0.(X_9+X_3)$. The output of the fourth multiplier 5.16 is then $C_3.X_6$. The output of the buffer 5.21 is $G_0.X_4$. The output of the buffer 5.22 is $C_2.(X_7+X_5)$. The output of the buffer 5.23 is $C_1.(X_8+X_4)$. The output of the circuit is selected from the output of the adder 5.28 which is then $C_0.(X_9+X_3)+C_1.(X_8+X_4)+C_2.(X_7+X_5)+C_3.X_6$ corresponding to the fourth stationary output sample.

On stage 11, $X_9$ is presented again as input of the first buffer 5.1. $X_8$ is presented as the input of the third buffer 5.3, $X_7$ as the input of the buffer 5.4, $X_6$ as the input of the buffer 5.5, $X_5$ as the input of buffer 5.6 and $X_4$ as the output of buffer 5.6. This input path is then frozen in this state that will be the input of the last stages of ending transient samples.

The output of the first multiplier 5.13 is now $G_2.X_6$. The output of the second multiplier 5.14 is then $G_5.X_9$. The output of the third multiplier 5.15 is then $G_4.X_8$. The output of the fourth multiplier 5.16 is then $G_3.X_7$. The output of the circuit is selected from the output of the adder 5.28 which is then $G_0.X_4+G_1.X_5+G_2.X_6+G_3.X_7+G_4.X_8+G_5.X_9$ corresponding to the first ending transient output sample.

On stage 12, the output of the first multiplier 5.13 is now $H_1.X_6$. The output of the second multiplier 5.14 is then $H_4.X_9$. The output of the third multiplier 5.15 is then $H_3.X_8$. The output of the fourth multiplier 5.16 is then $H_2.X_7$. The output of the circuit is selected from the output of the adder 5.28 which is then $H_0.X_5+H_1.X_6+H_2.X_7+H_3.X_8+H_4.X_9$ corresponding to the second ending transient output sample.

On stage 13, the output of the first multiplier 5.13 is now $I_0.X_6$. The output of the second multiplier 5.14 is then $I_3.X_9$. The output of the third multiplier 5.15 is then $I_2.X_8$. The output of the fourth multiplier 5.16 is then $I_1.X_7$. The output of the circuit is selected from the output of the adder 5.28 which is then $I_0.X_6+I_1.X_7+I_2.X_8+I_3.X_9$ corresponding to the last ending transient output sample.

While being described with a filter width of $M=7$, the above design can be extended to any odd size of filter from $M=3$. It is therefore possible to compute the result of applying a FIR centred symmetric filter of any given size $M=2L+1$ to a finite set of N samples with a transient computation and stationary computation using the same $L+1$ multipliers as the only multipliers. This computation is done in $N+L$ stages of computation each stage of computation is defined by a run of the multipliers.

**Claims**

1.  Method for computing the result of the application of a finite impulse response, FIR, filter having an odd number $M=2.L+1$ of symmetrical coefficients around a central tap where $M$ and $L$ are positive integers, to a finite set of N input samples indexed from 0 to $N-1$ , said method comprising :

    - a step, called stationary step, to compute output samples from index L to index $N-L-1$ of said FIR filter being applied to said input samples, and **characterized in that** it further comprises :
    - a step, called first transient step, to compute output samples from index $i$ running from 0 to L-1 of a filter of variable width L+i+1 with dedicated coefficients being applied to the first L+i+1 input samples of said set.
    - a step, called second transient step, to compute output samples from index i running from $N-L$ to $N-1$ of a filter of variable width $L+i-N+1$ with dedicated coefficients being applied to the last $L$ input samples of said set.

2.  Filtering device for computing the result of the application of a finite impulse response, FIR, filter having an odd number $M=2.L+1$ of symmetrical coefficients around a central tap where M and L are positive integers, to a finite set of N samples indexed from $0$ to $N-1$ said device comprising :

    - means, called stationary means, to compute output samples from index L to index $N-L-1$ by applying said FIR filter ; and **characterized in that** it further comprise :
    - means, called transient means, to compute output samples from index $i$ running from $0$ to $L-1$ of a filter of variable width $L+i+1$ with dedicated coefficients being applied to the first L+i+1 input samples of said set, and from index $i$ running from $N-L$ to N-1 of a filter of variable width $L+i-N+1$ with dedicated coefficients being applied to the last $L$ input samples of said set.

3.  Filtering device according to claim 2, **characterized in that** the stationary means and the transient means are built using the same $L+1$ multipliers (5.13, 5.14, 5.15) as the only multipliers.

4.  Filtering device according to claim 3, **characterized in that** the filtering operations are done in exactly $N+L$ stages of computation, where the stage of computation is defined by a run of the multipliers (5.13,5.14,5.15).

**Patentansprüche**

1.  Verfahren zum Berechnen des Ergebnisses der Anwendung eines Filters mit endlicher Impulsantwort (FIR-Filters) mit einer ungeraden Anzahl. M=2.L+1 symmetrischer Koeffizienten um einen zentralen Abgriff, wobei M und L positive ganze Zahlen sind, auf eine endliche Gruppe von N Eingangsabtastungen, die von 0 bis N-1 indiziert sind, wobei das Verfahren folgendes aufweist:

- einen Schritt, der stationärer Schritt genannt wird, um Ausgangsabtastungen vom Index L zum Index N-L-1 des FIR-Filters zu berechnen, das auf die Eingangsabtastungen angewendet wird, und **dadurch gekennzeichnet, dass** es weiterhin folgendes aufweist:
- einen Schritt, der erster Übergangsschritt genannt wird, um Ausgangsabtastungen vom Index i, der von 0 bis L-1 läuft, eines Filters variabler Breite L+i+1 mit bestimmten Koeffizienten zu berechnen, das auf die ersten L+i+1 Eingangsabtastungen der Gruppe angewendet wird,
- einen Schritt, der zweiter Übergangsschritt genannt wird, um Ausgangsabtastungen vom Index i, der von N-L bis N-1 läuft, eines Filters variabler Breite L+i-N+1 mit bestimmten Koeffizienten zu berechnen, das auf die letzten L Eingangsabtastungen der Gruppe angewendet wird.

**2.** Filtervorrichtung zum Berechnen des Ergebnisses der Anwendung eines Filters mit endlicher Impulsantwort (FIR-Filters) mit einer ungeraden Anzahl M=2.L+1 symmetrischer Koeffizienten um einen zentralen Abgriff, wobei M und L positive ganze Zahlen sind, auf eine endliche Gruppe von N Abtastungen, die von 0 bis N-1 indiziert sind, wobei die Vorrichtung folgendes aufweist:

- eine Einrichtung, die stationäre Einrichtung genannt wird, um Ausgangsabtastungen vom Index L zum Index N-L-1 durch Anwenden des FIR-Filters zu berechnen;
und **dadurch gekennzeichnet, dass** sie weiterhin folgendes aufweist:
- eine Einrichtung, die Übergangseinrichtung genannt wird, um Ausgangsabtastungen vom Index i, der von 0 bis L-1 läuft, eines Filters variabler Breite L+i+1 mit bestimmten Koeffizienten, das auf die ersten L+i+1 Eingangsabtastungen der Gruppe angewendet wird, und vom Index i, der von N-L bis N-1 läuft, eines Filters variabler Breite L+i-N+1 mit bestimmten Koeffizienten, das auf die letzten L Eingangsabtastungen der Gruppe angewendet wird, zu berechnen.

**3.** Filtervorrichtung nach Anspruch 2, **dadurch gekennzeichnet, dass** die stationäre Einrichtung und die Übergangseinrichtung unter Verwendung derselben L+1 Multiplizierer (5.13, 5.14, 5.15) als die einzigen Multiplizierer aufgebaut sind.

**4.** Filtervorrichtung nach Anspruch 3, **dadurch gekennzeichnet, dass** die Filteroperationen in genau N+L Berechnungsstufen durchgeführt werden, wobei die Berechnungsstufe durch einen Betreib der Multiplizierer (5.13, 5.14, 5.15) definiert ist.

**Revendications**

**1.** Procédé pour calculer le résultat d'une application d'un filtre à réponse impulsionnelle finie, RIF, ayant un nombre impair *M=2.L+1* de coefficients symétriques autour d'un élément central où *M* et *L* sont des entiers positifs, à un ensemble fini de N échantillons d'entrée indexés de *0* à *N-1,* ledit procédé comprenant :

- une étape, appelée étape stationnaire, de calcul d'échantillons de sortie de l'index *L* à l'index *N-L-1* dudit filtre RIF étant appliqué auxdits échantillons d'entrée, et **caractérisé en ce qu'**il comporte en outre :
- une étape, appelée première étape transitoire, de calcul d'échantillons de sortie de l'index *i* allant de *0* à *L-1* d'un filtre de largeur variable *L+i+1* avec des coefficients dédiés étant appliqués aux *L+i+1* premiers échantillons d'entrée dudit ensemble,
- une étape, appelée seconde étape transitoire, de calcul d'échantillons de sortie de l'index *i* allant de *N-L* à *N-1* d'un filtre de largeur variable *L+i-N+1* avec des coefficients dédiés étant appliqués aux *L* derniers échantillons d'entrée dudit ensemble.

**2.** Dispositif de filtrage pour calculer le résultat d'une application d'un filtre à réponse impulsionnelle finie, RIF, ayant un nombre impair *M=2.L+1* de coefficients symétriques autour d'un élément central où *M* et *L* sont des entiers positifs, à un ensemble fini de N échantillons d'entrée indexés de *0* à *N-1,* ledit dispositif comprenant :

- des moyens, appelés moyens stationnaires, de calcul d'échantillons de sortie de l'index *L* à l'index *N-L-1* en appliquant ledit filtre RIF,
et **caractérisé en ce qu'**il comporte en outre :
- des moyens, appelés moyens transitoires, de calcul d'échantillons de sortie de l'index *i* allant de *0* à *L-1* d'un filtre de largeur variable $L+i+1$ avec des coefficients dédiés étant appliqués aux $L$+i+1 premiers échantillons d'entrée dudit ensemble, et de l'index $i$ allant de $N-L$ à $N-1$ d'un filtre de largeur variable $L+i-N+1$ avec des coefficients dédiés étant appliqués aux $L$ derniers échantillons d'entrée dudit ensemble.

3. Dispositif de filtrage selon la revendication 2, **caractérisé en ce que** les moyens stationnaires et les moyens transitoires sont construits en utilisant les mêmes $L+1$ multiplieurs (5.13, 5.14, 5.15) comme multiplieurs uniques.

4. Dispositif de filtrage selon la revendication 3, **caractérisé en ce que** les opérations de filtrage sont faites en exactement $N+L$ étages de calcul, où l'étage de calcul est défini par une opération des multiplieurs (5.13, 5.14, 5.15).

1.1

| j-4 | j-3 | j-2 | j-1 | j | j+1 | j+2 | j+3 | j+4 |
|-----|-----|-----|-----|---|-----|-----|-----|-----|

1.2

| c0 | c1 | c2 | c3 | c4 |
|----|----|----|----|----|

1.3

| j-4 | j-3 | j-2 | j-1 | j | j+1 | j+2 | j+3 | j+4 |
|-----|-----|-----|-----|---|-----|-----|-----|-----|

**Fig. 1**

2.1

2.3

2.4

2.5

2.6

2.7

2.8

2.9

2.2

**Fig. 2**

3.4

3.5

3.6

3.7

3.8

**Fig. 3**

4.4

4.5

4.6

4.7

4.8

**Fig. 4**

**Fig. 5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090067520 A1